(19) **Europäisches Patentamt / European Patent Office / Office européen des brevets**

(11) **EP 4 531 292 A1**

(12) # EUROPEAN PATENT APPLICATION

(43) Date of publication:
02.04.2025 Bulletin 2025/14

(21) Application number: 23199662.0

(22) Date of filing: 26.09.2023

(51) International Patent Classification (IPC):
$H04B\ 1/04$ (2006.01)     $H04B\ 1/62$ (2006.01)
$H04B\ 1/02$ (2006.01)     $H04B\ 1/10$ (2006.01)
$H03F\ 1/32$ (2006.01)     $G06N\ 3/02$ (2006.01)

(52) Cooperative Patent Classification (CPC):
H04B 1/0475; G06N 3/02; H03F 1/3241;
H03F 3/19; H03F 3/245; H04B 1/02; H04B 1/10;
H04B 1/62; H03F 2200/451

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: Nokia Solutions and Networks Oy
02610 Espoo (FI)

(72) Inventors:
• BARBU, Oana-Elena
  9220 Aalborg (DK)
• JALILI, Feridoon
  9260 Gistrup (DK)
• KORPI, Dani Johannes
  33100 Tampere (FI)
• REZAIE, Sajad
  9220 Aalborg (DK)

(74) Representative: Nokia EPO representatives
Nokia Technologies Oy
Karakaari 7
02610 Espoo (FI)

(54) **COLLABORATIVE CONTROL OF POWER AMPLIFIER RELATED DISTORTIONS IN A RADIO TRANSMITTER DEVICE, AND RELATED DEVICES AND METHODS**

(57) Devices and methods for collaborative control of power amplifier related distortions in a radio transmitter device are disclosed. At least some example embodiments may allow controlling the distortions in the power amplifiers used in the radio transmitter devices in way that also takes into account various emission requirements.

FIG. 3

**Description**

**TECHNICAL FIELD**

The disclosure relates generally to communications and, more particularly but not exclusively, to collaborative control of power amplifier related distortions in a radio transmitter device, as well as related devices and methods.

**BACKGROUND**

Power amplifiers used in radio transmitter devices included, e.g., in client devices or user equipment (UE) such as mobile phones and the like, may have non-linearity or distortion that needs to be controlled to improve power efficiency and overall performance.

Furthermore, strict emission requirements have been introduced for the client devices in fifth generation (5G) and sixth generation (6G) wireless networks.

Accordingly, at least in some situations, there may be a need for controlling the non-linearity in the power amplifiers used in the radio transmitter devices in way that also takes into account the emission requirements.

**SUMMARY**

The scope of protection sought for various example embodiments of the invention is set out by the independent claims. The example embodiments and features, if any, described in this specification that do not fall under the scope of the independent claims are to be interpreted as examples useful for understanding various example embodiments of the invention.

An example embodiment of a radio transmitter device comprises a power amplifier, at least one processor, and at least one memory storing instructions that, when executed by the at least one processor, cause the radio transmitter device at least to perform generating a transmission signal comprising an orthogonal frequency division multiplexing (OFDM) modulated information bit stream. The instructions, when executed by the at least one processor, further cause the radio transmitter device at least to perform applying a first distortion operation to the generated transmission signal to control out-of-band distortion to be introduced at least by the power amplifier. The instructions, when executed by the at least one processor, further cause the radio transmitter device at least to perform providing the transmission signal to the power amplifier for power amplification after the application of the first distortion operation. The instructions, when executed by the at least one processor, further cause the radio transmitter device at least to perform transmitting the power-amplified transmission signal to a radio receiver device over a wireless channel for collaborative processing via a second distortion operation to control in-band distortion.

In an example embodiment, alternatively or in addition to the above-described example embodiments, the out-of-band distortion comprises an adjacent channel leakage ratio (ACLR).

In an example embodiment, alternatively or in addition to the above-described example embodiments, the application of the first distortion operation is performed at least partially with a first neural network (NN).

In an example embodiment, alternatively or in addition to the above-described example embodiments, the first distortion operation comprises a digital pre-distortion (DPD) operation, and the second distortion operation comprises a digital post-distortion (DPoD) operation.

An example embodiment of a radio transmitter device comprises a power amplifier and means for causing the radio transmitter device at least to perform generating a transmission signal comprising an orthogonal frequency division multiplexing (OFDM) modulated information bit stream. The means are further configured to cause the radio transmitter device at least to perform applying a first distortion operation to the generated transmission signal to control out-of-band distortion to be introduced at least by the power amplifier. The means are further configured to cause the radio transmitter device at least to perform providing the transmission signal to the power amplifier for power amplification after the application of the first distortion operation. The means are further configured to cause the radio transmitter device at least to perform transmitting the power-amplified transmission signal to a radio receiver device over a wireless channel for collaborative processing via a second distortion operation to control in-band distortion.

In an example embodiment, alternatively or in addition to the above-described example embodiments, the out-of-band distortion comprises an adjacent channel leakage ratio (ACLR).

In an example embodiment, alternatively or in addition to the above-described example embodiments, the application of the first distortion operation is performed at least partially with a first neural network (NN).

In an example embodiment, alternatively or in addition to the above-described example embodiments, the first distortion operation comprises a digital pre-distortion (DPD) operation, and the second distortion operation comprises a digital post-distortion (DPoD) operation.

An example embodiment of a method comprises generating, by a radio transmitter device, a transmission signal comprising an orthogonal frequency division multiplexing (OFDM) modulated information bit stream. The method further comprises applying, by the radio transmitter device, a first distortion operation to the generated transmission signal to control out-of-band distortion to be introduced at least by a power amplifier comprised in the radio transmitter device. The method further comprises providing, by the radio transmitter device, the transmission signal to the power amplifier for power amplification after the application of the first distortion operation. The method further comprises transmitting, by the radio transmitter device, the power-amplified transmission signal to a radio receiver device over a wireless channel for collaborative processing via a second distortion operation to control in-band distortion.

In an example embodiment, alternatively or in addition to the above-described example embodiments, the out-of-band distortion comprises an adjacent channel leakage ratio (ACLR).

In an example embodiment, alternatively or in addition to the above-described example embodiments, the application of the first distortion operation is performed at least partially with a first neural network (NN).

In an example embodiment, alternatively or in addition to the above-described example embodiments, the first distortion operation comprises a digital pre-distortion (DPD) operation, and the second distortion operation comprises a digital post-distortion (DPoD) operation.

An example embodiment of a computer program comprises instructions for causing a radio transmitter device to perform at least the following: generating a transmission signal comprising an orthogonal frequency division multiplexing (OFDM) modulated information bit stream; applying a first distortion operation to the generated transmission signal to control out-of-band distortion to be introduced at least by a power amplifier comprised in the radio transmitter device; providing the transmission signal to the power amplifier for power amplification after the application of the first distortion operation; and transmitting the power-amplified transmission signal to a radio receiver device over a wireless channel for collaborative processing via a second distortion operation to control in-band distortion.

An example embodiment of a radio receiver device comprises at least one processor, and at least one memory storing instructions that, when executed by the at least one processor, cause the radio receiver device at least to perform receiving a power-amplified transmission signal from a radio transmitter device over a wireless channel for collaborative processing. The received transmission signal has been processed via a first distortion operation to control out-of-band distortion. The instructions, when executed by the at least one processor, further cause the radio receiver device at least to perform demodulating the received transmission signal. The instructions, when executed by the at least one processor, further cause the radio receiver device at least to perform applying a second distortion operation to the demodulated transmission signal to control in-band distortion introduced at least by the power amplification.

In an example embodiment, alternatively or in addition to the above-described example embodiments, the in-band distortion comprises an error vector magnitude (EVM).

In an example embodiment, alternatively or in addition to the above-described example embodiments, the application of the second distortion operation is performed at least partially with a second neural network (NN).

In an example embodiment, alternatively or in addition to the above-described example embodiments, the first distortion operation comprises a digital pre-distortion (DPD) operation, and the second distortion operation comprises a digital post-distortion (DPoD) operation.

An example embodiment of a radio receiver device comprises means for causing the radio receiver device at least to perform receiving a power-amplified transmission signal from a radio transmitter device over a wireless channel for collaborative processing. The received transmission signal has been processed via a first distortion operation to control out-of-band distortion. The means are further configured to cause the radio receiver device at least to perform demodulating the received transmission signal. The means are further configured to cause the radio receiver device at least to perform applying a second distortion operation to the demodulated transmission signal to control in-band distortion introduced at least by the power amplification.

In an example embodiment, alternatively or in addition to the above-described example embodiments, the in-band distortion comprises an error vector magnitude (EVM).

In an example embodiment, alternatively or in addition to the above-described example embodiments, the application of the second distortion operation is performed at least partially with a second neural network (NN).

In an example embodiment, alternatively or in addition to the above-described example embodiments, the first distortion operation comprises a digital pre-distortion (DPD) operation, and the second distortion operation comprises a digital post-distortion (DPoD) operation.

An example embodiment of a method comprises receiving, at a radio receiver device, a power-amplified transmission signal from a radio transmitter device over a wireless channel for collaborative processing. The received transmission signal has been processed via a first distortion operation to control out-of-band distortion. The method further comprises demodulating, by the radio receiver device, the received transmission signal. The method further comprises applying, by the radio receiver device, a second distortion operation to the demodulated transmission signal to control in-band distortion introduced at least by the power amplification.

In an example embodiment, alternatively or in addition to the above-described example embodiments, the in-band distortion comprises an error vector magnitude (EVM).

In an example embodiment, alternatively or in addition to the above-described example embodiments, the application of the second distortion operation is performed at least partially with a second neural network (NN).

In an example embodiment, alternatively or in addition to the above-described example embodiments, the first distortion operation comprises a digital pre-distortion (DPD) operation, and the second distortion operation comprises a digital post-distortion (DPoD) operation.

An example embodiment of a computer program comprises instructions for causing a radio receiver device to perform at least the following: receiving a power-amplified transmission signal from a radio transmitter device over a wireless channel for collaborative processing, the received transmission signal having been processed via a first distortion operation to control out-of-band distortion; demodulating the received transmission signal; and applying a second distortion operation to the demodulated transmission signal to control in-band distortion introduced at least by the power amplification.

An example embodiment of a first training apparatus comprises at least one processor, and at least one memory storing instructions that, when executed by the at least one processor, cause the first training apparatus at least to perform at least one of: training a first neural network (NN) used to apply a first distortion operation in a radio transmitter device to control out-of-band distortion, via minimizing a first intermediate cost function reflecting at least the out-of-band distortion by adjusting one or more trainable parameters of the first NN; or training a second NN used to apply a second distortion operation in a radio receiver device to control in-band distortion, via minimizing a second intermediate cost function reflecting at least the in-band distortion by adjusting one or more trainable parameters of the second NN. When only training the first NN or the second NN, the instructions, when executed by the at least one processor, further cause the first training apparatus at least to perform indicating to a second training apparatus to perform training the second NN or the first NN, respectively.

In an example embodiment, alternatively or in addition to the above-described example embodiments, the instructions, when executed by the at least one processor, further cause the first training apparatus to perform the training via minimizing a combined cost function, the combined cost function being a combination of the first intermediate cost function and the second intermediate cost function.

In an example embodiment, alternatively or in addition to the above-described example embodiments, the instructions, when executed by the at least one processor, further cause the first training apparatus to perform training at least one of the first NN or the second NN via training phases alternating with interference phases.

In an example embodiment, alternatively or in addition to the above-described example embodiments, the instructions, when executed by the at least one processor, further cause the first training apparatus to perform training the first NN via supervised learning or reinforcement learning.

In an example embodiment, alternatively or in addition to the above-described example embodiments, the instructions, when executed by the at least one processor, further cause the first training apparatus to perform training the second NN via supervised learning.

In an example embodiment, alternatively or in addition to the above-described example embodiments, the first distortion operation comprises a digital pre-distortion (DPD) operation, and the second distortion operation comprises a digital post-distortion (DPoD) operation.

An example embodiment of a first training apparatus comprises means for causing the first training apparatus at least to perform at least one of: training a first neural network (NN) used to apply a first distortion operation in a radio transmitter device to control out-of-band distortion, via minimizing a first intermediate cost function reflecting at least the out-of-band distortion by adjusting one or more trainable parameters of the first NN; or training a second NN used to apply a second distortion operation in a radio receiver device to control in-band distortion, via minimizing a second intermediate cost function reflecting at least the in-band distortion by adjusting one or more trainable parameters of the second NN. When only training the first NN or the second NN, the means are further configured to cause the first training apparatus at least to perform indicating to a second training apparatus to perform training the second NN or the first NN, respectively.

In an example embodiment, alternatively or in addition to the above-described example embodiments, the means are further configured to cause the first training apparatus to perform the training via minimizing a combined cost function, the combined cost function being a combination of the first intermediate cost function and the second intermediate cost function.

In an example embodiment, alternatively or in addition to the above-described example embodiments, the means are further configured to cause the first training apparatus to perform training at least one of the first NN or the second NN via training phases alternating with interference phases.

In an example embodiment, alternatively or in addition to the above-described example embodiments, the means are further configured to cause the first training apparatus to perform training the first NN via supervised learning or reinforcement learning.

In an example embodiment, alternatively or in addition to the above-described example embodiments, the means are further configured to cause the first training apparatus to perform training the second NN via supervised learning.

In an example embodiment, alternatively or in addition to the above-described example embodiments, the first distortion operation comprises a digital pre-distortion (DPD) operation, and the second distortion operation comprises a digital post-distortion (DPoD) operation.

An example embodiment of a method comprises at least one of: training, by a first training apparatus, a first neural network (NN) used to apply a first distortion operation in a radio transmitter device to control out-of-band distortion, via minimizing a first intermediate cost function reflecting the out-of-band distortion by adjusting one or more trainable parameters of the first NN; or training, by the first training apparatus, a second NN used to apply a second distortion operation in a radio receiver device to control in-band distortion, via minimizing a second intermediate cost function reflecting the in-band distortion by adjusting one or more trainable parameters of the second NN. When only training the first NN or the second NN, the method further comprises indicating by the first training apparatus to a second training apparatus to perform training the second NN or the first NN, respectively.

In an example embodiment, alternatively or in addition to the above-described example embodiments, the training is performed via minimizing a combined cost function, the combined cost function being a combination of the first intermediate cost function and the second intermediate cost function.

In an example embodiment, alternatively or in addition to the above-described example embodiments, at least one of the first NN or the second NN is trained via training phases alternating with interference phases.

In an example embodiment, alternatively or in addition to the above-described example embodiments, the first NN is trained via supervised learning or reinforcement learning.

In an example embodiment, alternatively or in addition to the above-described example embodiments, the second NN is trained via supervised learning.

In an example embodiment, alternatively or in addition to the above-described example embodiments, the first distortion operation comprises a digital pre-distortion (DPD) operation, and the second distortion operation comprises a digital post-distortion (DPoD) operation.

An example embodiment of a computer program comprises instructions for causing a first training apparatus to perform at least the following: at least one of training a first neural network (NN) used to apply a first distortion operation in a radio transmitter device to control out-of-band distortion, via minimizing a first intermediate cost function reflecting the out-of-band distortion by adjusting one or more trainable parameters of the first NN; or training a second NN used to apply a second distortion operation in a radio receiver device to control in-band distortion, via minimizing a second intermediate cost function reflecting the in-band distortion by adjusting one or more trainable parameters of the second NN; and when only training the first NN or the second NN, indicating to a second training apparatus to perform training the second NN or the first NN, respectively.

An example embodiment of a second training apparatus comprises at least one processor, and at least one memory storing instructions that, when executed by the at least one processor, cause the second training apparatus at least to perform receiving, from a first training apparatus, an indication to train a first neural network (NN) used to apply a first distortion operation in a radio transmitter device to control out-of-band distortion, or to train a second NN used to apply a second distortion operation in a radio receiver device to control in-band distortion. In accordance with the received indication, the instructions, when executed by the at least one processor, further cause the second training apparatus at least to perform one of: training the first NN via minimizing a first intermediate cost function reflecting the out-of-band distortion by adjusting one or more trainable parameters of the first NN, or training the second NN via minimizing a second intermediate cost function reflecting the in-band distortion by adjusting one or more trainable parameters of the second NN.

In an example embodiment, alternatively or in addition to the above-described example embodiments, the first distortion operation comprises a digital pre-distortion (DPD) operation, and the second distortion operation comprises a digital post-distortion (DPoD) operation.

An example embodiment of a second training apparatus comprises means for causing the second training apparatus at least to perform receiving, from a first training apparatus, an indication to train a first neural network (NN) used to apply a first distortion operation in a radio transmitter device to control out-of-band distortion, or to train a second NN used to apply a second distortion operation in a radio receiver device to control in-band distortion. In accordance with the received indication, the means are further configured to cause the second training apparatus at least to perform one of: training the first NN via minimizing a first intermediate cost function reflecting the out-of-band distortion by adjusting one or more trainable parameters of the first NN, or training the second NN via minimizing a second intermediate cost function reflecting the in-band distortion by adjusting one or more trainable parameters of the second NN.

In an example embodiment, alternatively or in addition to the above-described example embodiments, the first distortion operation comprises a digital pre-distortion (DPD) operation, and the second distortion operation comprises a digital post-distortion (DPoD) operation.

An example embodiment of a method comprises receiving, at a second training apparatus from a first training apparatus, an indication to train a first neural network (NN) used to apply a first distortion operation in a radio transmitter device to control out-of-band distortion, or to train a second NN used to apply a second distortion operation in a radio receiver device to control in-band distortion. In accordance with the received indication, the method further comprises performing one of: training, by the second training apparatus, the first NN via minimizing a first intermediate cost function reflecting the out-of-band distortion by adjusting one or more trainable parameters of the first NN, or training, by the second training apparatus, the second NN via minimizing a second intermediate cost function reflecting the in-band distortion by adjusting one or more trainable parameters of the second NN.

In an example embodiment, alternatively or in addition to the above-described example embodiments, the first distortion operation comprises a digital pre-distortion (DPD) operation, and the second distortion operation comprises a digital post-distortion (DPoD) operation.

An example embodiment of a computer program comprises instructions for causing a secopnd training apparatus to perform at least the following: receiving from a first training apparatus an indication to train a first neural network (NN) used to apply a first distortion operation in a radio transmitter device to control out-of-band distortion, or to train a second NN used to apply a second distortion operation in a radio receiver device to control in-band distortion; and in accordance with the received indication, performing one of: training the first NN via minimizing a first intermediate cost function reflecting the out-of-band distortion by adjusting one or more trainable parameters of the first NN, or training the second NN via minimizing a second intermediate cost function reflecting the in-band distortion by adjusting one or more trainable parameters of the second NN.

## DESCRIPTION OF THE DRAWINGS

The accompanying drawings, which are included to provide a further understanding of the embodiments and constitute a part of this specification, illustrate embodiments and together with the description help to explain the principles of the embodiments. In the drawings:

FIG. 1 shows an example embodiment of the subject matter described herein illustrating an example system, where various embodiments of the present disclosure may be implemented;

FIG. 2A shows an example embodiment of the subject matter described herein illustrating a radio transmitter device;

FIG. 2B shows an example embodiment of the subject matter described herein illustrating a radio receiver device;

FIG. 2C shows an example embodiment of the subject matter described herein illustrating a first training apparatus;

FIG. 2D shows an example embodiment of the subject matter described herein illustrating a second training apparatus;

FIG. 3 shows an example embodiment of the subject matter described herein illustrating an architecture for the disclosed collaborative control between a radio transmitter device and a radio receiver device;

FIG. 4 shows an example embodiment of the subject matter described herein illustrating an architecture for the disclosed collaborative training between a first training apparatus and a second training apparatus;

FIGS. 5A and 5B show example embodiments of the subject matter described herein illustrating disclosed methods for a radio transmitter device and a radio receiver device, respectively; and

FIGS. 6A and 6B show example embodiments of the subject matter described herein illustrating disclosed methods for a first training apparatus and a second training apparatus, respectively.

Like reference numerals are used to designate like parts in the accompanying drawings.

## DETAILED DESCRIPTION

Reference will now be made in detail to embodiments, examples of which are illustrated in the accompanying drawings. The detailed description provided below in connection with the appended drawings is intended as a description of the present examples and is not intended to represent the only forms in which the present example may be constructed or utilized. The description sets forth the functions of the example and the sequence of steps for constructing and operating the example. However, the same or equivalent functions and sequences may be accomplished by different examples.

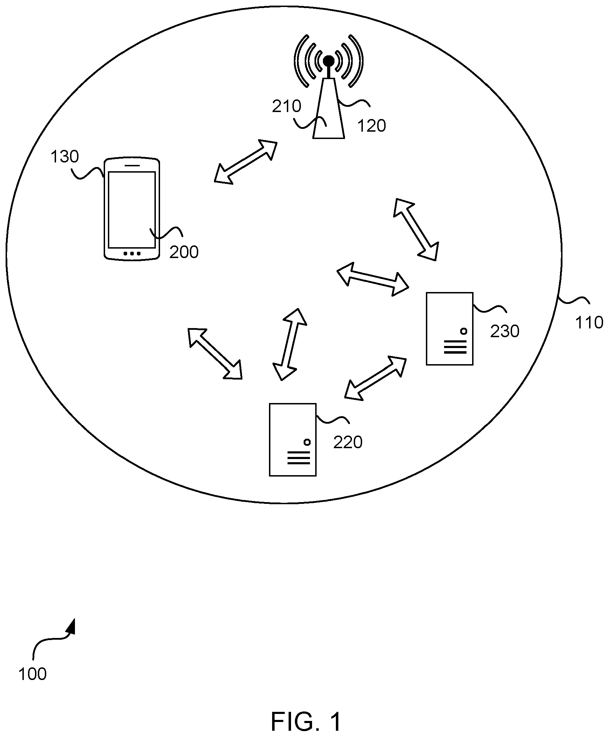

Fig. 1 illustrates an example system 100, where various embodiments of the present disclosure may be implemented. The system 100 may comprise, e.g., a fifth generation (5G) or sixth generation (6G) communications network 110. An example representation of the system 100 is shown depicting a network node device 120 and a client device 130. At least in some embodiments, the communications network 110 may comprise one or more massive machine-to-machine (M2M) network(s), massive machine type communications (mMTC) network(s), internet of things (IoT) network(s), industrial internet-of-things (IIoT) network(s), enhanced mobile broadband (eMBB) network(s), ultra-reliable low-latency communication (URLLC) network(s), and/or the like. In other words, the communications network 110 may be configured to serve diverse service types and/or use cases, and it may logically be seen as comprising one or more networks.

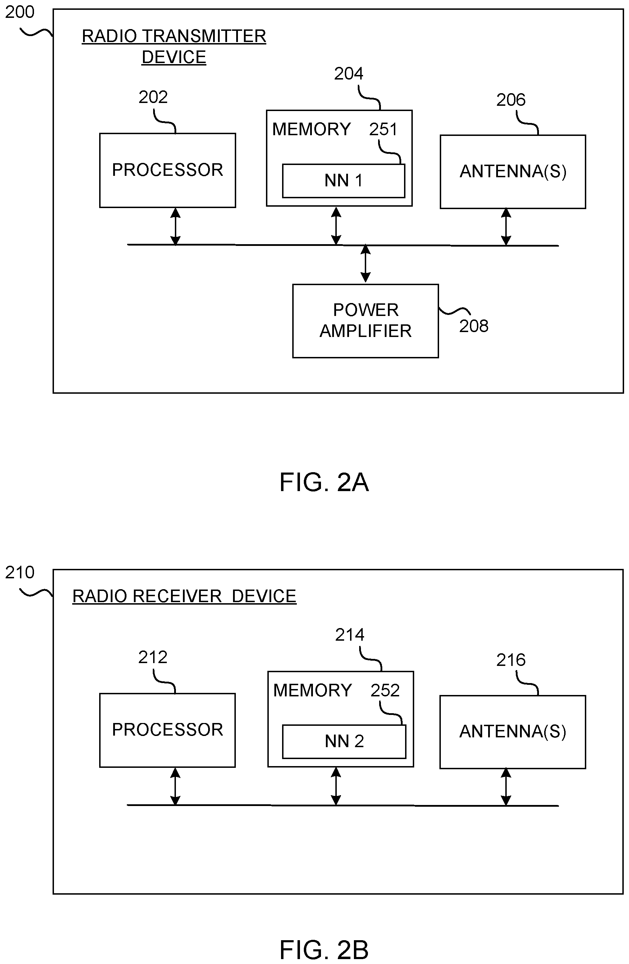

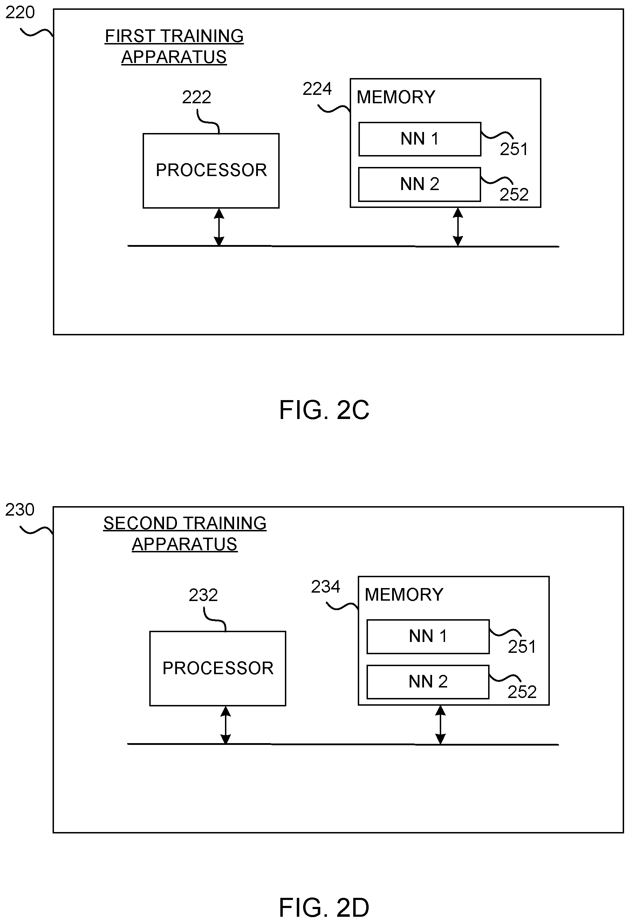

The client device 130 may include, e.g., a mobile phone, a smartphone, a tablet computer, a smart watch, or any handheld, portable and/or wearable device. The terminal device 130 may also be referred to as a user equipment (UE). The network node device 120 may comprise, e.g., a base station. The base station may include, e.g., a 5G or 6G base station (gNB) or any device suitable for providing an air interface for client devices to connect to a wireless network via wireless transmissions. The client device 130 may comprise a radio transmitter device 200 of Fig. 2A, and/or the network node device 120 may comprise a radio receiver device 210 of Fig. 2B. Furthermore, system 100 may comprise a first training apparatus 220 of Fig. 2C and/or a second training apparatus 230 of Fig. 2D. At least in some embodiments, the first training apparatus 220 and/or the second training apparatus 230 may be discrete entities (as shown in Fig. 1), whereas in other embodiments, the first training apparatus 220 may be comprised in the radio transmitter device 200, and/or the second training apparatus 230 may be comprised in the radio receiver device 210 (not shown in Fig. 1).

In the following, various example embodiments will be discussed. At least some of these example embodiments described herein may allow collaborative (i.e., between the radio transmitter device 200 and the radio receiver device 210) control of power amplifier related distortions in the radio transmitter device 200.

Furthermore, at least some of the example embodiments described herein may allow collaborative digital pre-distortion (DPD) and digital post-distortion (DPoD), optimizing the division of these tasks among the radio transmitter device 200 (e.g., in the client device 130) and radio receiver device 210 (e.g., in the network node device 120) to meet adjacent channel leakage ratio (ACLR) and error vector magnitude (EVM) targets.

Furthermore, at least some of the example embodiments described herein may allow designing a radio transmitter device 200 (e.g., in the client device 130) in high compression (i.e., with high ACLR and EVM) in a way that improves power efficiency.

Furthermore, at least some of the example embodiments described herein may allow a two-sided technique to control for the power amplifier non-linearities by decoupling out-of-band (i.e., ACLR) and in-band distortion (i.e., EVM) minimization tasks and distributing them between the radio transmitter device 200 (e.g., in the client device 130) and the radio receiver device 210 (e.g., in the network node device 120). For example, at least some of the example embodiments described herein may allow collaboratively implementing a DPoD technique in the radio receiver device 210 (e.g., in the network node device 120) and the radio transmitter device 200 (e.g., in the client device 130) -based DPD (or over-the-air (OTA) DPD), where the DPD may be optimized to reduce the ACLR while the DPoD may take care of the EVM.

Furthermore, at least some of the example embodiments described herein may allow reducing the computational load at the radio transmitter device 200 (e.g., in the client device 130).

Furthermore, at least some of the example embodiments described herein may allow providing robustness to channel conditions when training accounts for different channel and signal-to-interference-plus-noise ratio (SINR) regimes.

Fig. 2A is a block diagram of the radio transmitter device 200, in accordance with an example embodiment.

The radio transmitter device 200 comprises one or more processors 202 and one or more memories 204 that comprise computer program code. The radio transmitter device 200 further comprises a power amplifier 208. The radio transmitter device 200 may be configured to transmit information to other devices. In one example, the radio transmitter device 200 may transmit signalling information and data in accordance with at least one cellular communication protocol. The radio transmitter device 200 may be configured to provide at least one wireless radio connection, such as for example a 3GPP mobile broadband connection (e.g., 5G or 6G). The radio transmitter device 200 may comprise, or be configured to be coupled to, at least one antenna 206 to transmit radio frequency signals. The radio transmitter device 200 may also include other elements not shown in Fig. 2A.

Although the radio transmitter device 200 is depicted to include only one processor 202, the radio transmitter device 200 may include more processors. In an embodiment, the memory 204 is capable of storing instructions, such as an operating system and/or various applications. Furthermore, the memory 204 may include a storage that may be used to store, e.g., at least some of the information and data used in the disclosed embodiments, such as a first neural network (NN) 251 described in more detail below.

Furthermore, the processor 202 is capable of executing the stored instructions. In an embodiment, the processor 202 may be embodied as a multi-core processor, a single core processor, or a combination of one or more multi-core processors and one or more single core processors. For example, the processor 202 may be embodied as one or more of various processing devices, such as a coprocessor, a microprocessor, a controller, a digital signal processor (DSP), a processing circuitry with or without an accompanying DSP, or various other processing devices including integrated circuits such as, for example, an application specific integrated circuit (ASIC), a field programmable gate array (FPGA), a microcontroller unit (MCU), a hardware accelerator, a special-purpose computer chip, a neural network (NN) chip, an artificial intelligence (AI) accelerator, a tensor processing unit (TPU), a neural processing unit (NPU), or the like. In an embodiment, the processor 202 may be configured to execute hard-coded functionality. In an embodiment, the processor 202 is embodied as an executor of software instructions, wherein the instructions may specifically configure the processor 202 to perform the algorithms and/or operations described herein when the instructions are executed.

The memory 204 may be embodied as one or more volatile memory devices, one or more non-volatile memory devices, and/or a combination of one or more volatile memory devices and non-volatile memory devices. For example, the memory 204 may be embodied as semiconductor memories (such as mask ROM, PROM (programmable ROM), EPROM (erasable PROM), flash ROM, RAM (random access memory), etc.).

The radio transmitter device 200 may comprise any of various types of digital devices capable of transmitting radio communication in a wireless network. At least in some embodiments, the radio transmitter device 200 may be comprised in the client device 130.

When executed by the at least one processor 202, instructions stored in the at least one memory 204 cause the radio transmitter device 200 at least to perform generating a transmission signal comprising an orthogonal frequency division multiplexing (OFDM) modulated information bit stream.

The instructions, when executed by the at least one processor 202, further cause the radio transmitter device 200 at least to perform applying a first distortion operation to the generated transmission signal to control (e.g., suppress or reduce) out-of-band distortion to be introduced at least by the power amplifier 208.

For example, the out-of-band distortion may comprise an adjacent channel leakage ratio (ACLR). The ACLR refers to a ratio of a filtered mean power centered on an assigned channel frequency to a filtered mean power centered on an adjacent channel frequency. The EVM refers to a modulation quality metric used in digital communications. More specifically, the EVM is a measure of a deviation of actual modulation constellation points from their ideal locations in a modulation constellation diagram.

At least in some embodiments, the first distortion operation may comprise a digital pre-distortion (DPD) operation.

At least in some embodiments, the application of the first distortion operation may be performed at least partially with the first NN 251.

In other words, the ACLR control/reduction may be implemented in the radio transmitter device 200 (thereby ensuring that no other radio spectrum is polluted), e.g., as a combination of digital signal processing and the first NN 251.

The instructions, when executed by the at least one processor 202, further cause the radio transmitter device 200 at least to perform providing the transmission signal to the power amplifier 208 for power amplification after the application of the first distortion operation.

The instructions, when executed by the at least one processor 202, further cause the radio transmitter device 200 at least to perform transmitting the power-amplified transmission signal to the radio receiver device 210 over a wireless channel for collaborative processing via a second distortion operation to control in-band distortion. For example, the in-band distortion may comprise an error vector magnitude (EVM). At least in some embodiments, the second distortion operation may comprise a digital post-distortion (DPoD) operation.

Fig. 2B is a block diagram of the radio receiver device 210, in accordance with an example embodiment.

The radio receiver device 210 comprises one or more processors 212 and one or more memories 214 that comprise computer program code. The radio receiver device 210 may be configured to receive information from other devices. In one example, the radio receiver device 210 may receive signalling information and data in accordance with at least one cellular communication protocol. The radio receiver device 210 may be configured to provide at least one wireless radio connection, such as for example a 3GPP mobile broadband connection (e.g.,

5G or 6G). The radio receiver device 210 may comprise, or be configured to be coupled to, at least one antenna 216 to receive radio frequency signals. The radio receiver device 210 may also include other elements not shown in Fig. 2B.

Although the radio receiver device 210 is depicted to include only one processor 212, the radio receiver device 210 may include more processors. In an embodiment, the memory 214 is capable of storing instructions, such as an operating system and/or various applications. Furthermore, the memory 214 may include a storage that may be used to store, e.g., at least some of the information and data used in the disclosed embodiments, such as a second neural network (NN) 252 described in more detail below.

Furthermore, the processor 212 is capable of executing the stored instructions. In an embodiment, the processor 212 may be embodied as a multi-core processor, a single core processor, or a combination of one or more multi-core processors and one or more single core processors. For example, the processor 212 may be embodied as one or more of various processing devices, such as a coprocessor, a microprocessor, a controller, a digital signal processor (DSP), a processing circuitry with or without an accompanying DSP, or various other processing devices including integrated circuits such as, for example, an application specific integrated circuit (ASIC), a field programmable gate array (FPGA), a microcontroller unit (MCU), a hardware accelerator, a special-purpose computer chip, a neural network (NN) chip, an artificial intelligence (AI) accelerator, a tensor processing unit (TPU), a neural processing unit (NPU), or the like. In an embodiment, the processor 212 may be configured to execute hard-coded functionality. In an embodiment, the processor 212 is embodied as an executor of software instructions, wherein the instructions may specifically configure the processor 212 to perform the algorithms and/or operations described herein when the instructions are executed.

The memory 214 may be embodied as one or more volatile memory devices, one or more non-volatile memory devices, and/or a combination of one or more volatile memory devices and non-volatile memory devices. For example, the memory 214 may be embodied as semiconductor memories (such as mask ROM, PROM (programmable ROM), EPROM (erasable PROM), flash ROM, RAM (random access memory), etc.).

The radio receiver device 210 may comprise any of various types of digital devices capable of receiving radio communication in a wireless network. At least in some embodiments, the radio receiver device 210 may be comprised in the network node device 120 (e.g., a 5G or 6G base station).

When executed by the at least one processor 212, instructions stored in the at least one memory 214 cause the radio receiver device 210 at least to perform receiving the above-described power-amplified transmission signal from the radio transmitter device 200 over the wireless channel for collaborative processing. The received transmission signal has been processed via the first distortion operation to control (e.g., suppress or reduce) the out-of-band distortion, as discussed in more detail above in connection with Fig. 2A.

The instructions, when executed by the at least one processor 212, further cause the radio receiver device 210 at least to perform demodulating the received transmission signal.

The instructions, when executed by the at least one processor 212, further cause the radio receiver device 210 at least to perform applying the second distortion operation to the demodulated transmission signal to control the in-band distortion introduced at least by the power amplification. As discussed above, the in-band distortion may comprise an EVM, and/or the second distortion operation may comprise a DPoD operation.

At least in some embodiments, the application of the second distortion operation may be performed at least partially with the second NN 252.

In other words, the EVM control/reduction may be implemented in the radio receiver device 210, e.g., as a combination of digital signal processing and the second NN 252.

Further features of the radio receiver device 210 directly result from the functionalities and parameters of the radio transmitter device 200 and thus are not repeated here.

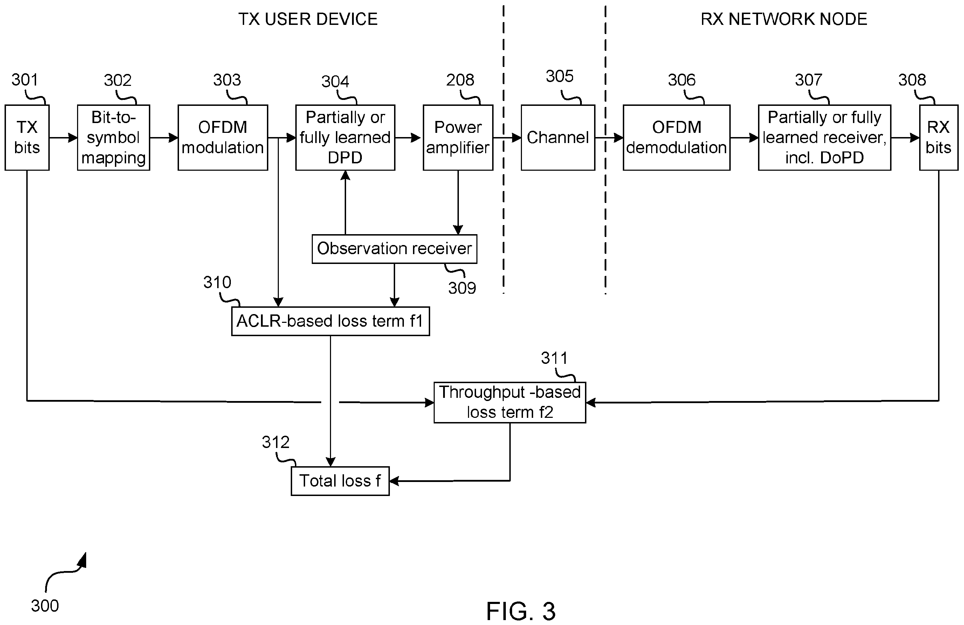

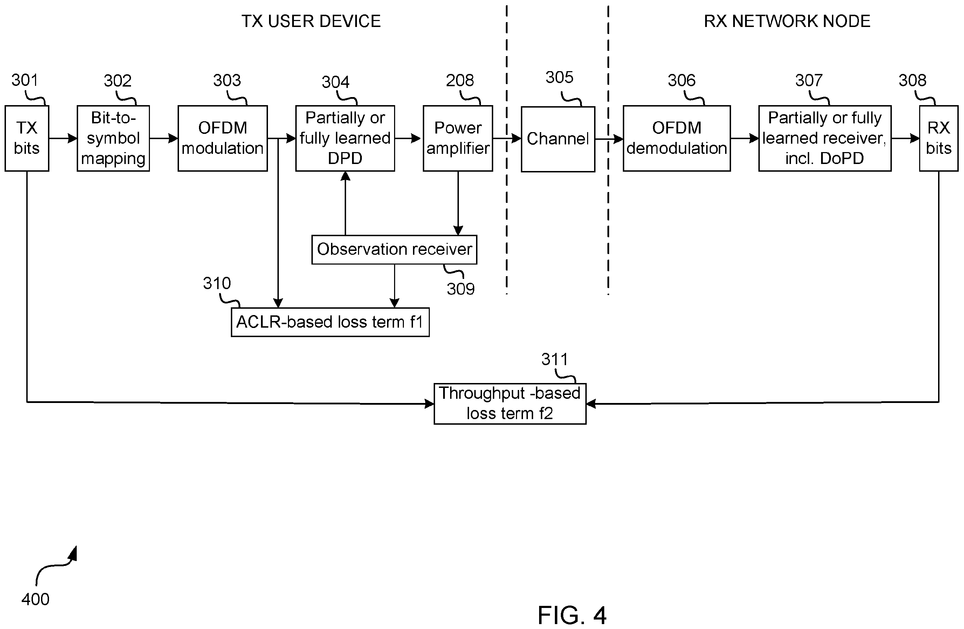

Diagram 300 of Fig. 3 illustrates an example architecture or structure that may be used for the disclosed collaborative control of power amplifier related distortions between the radio transmitter device 200 and the radio receiver device 210, and diagram 400 of Fig. 4 illustrates an example of an architecture or structure that may be used for the disclosed collaborative training between the radio transmitter device 200 and the radio receiver device 210 for the control of the power amplifier non-linearities.

In the examples of diagrams 300 and 400, blocks 301. 302, 303, 304, 309, 208 may be implemented in the radio transmitter device 200 (e.g., in the client device 130) (TX side), and blocks 306, 307, 308 may be implemented in the radio receiver device 210 (e.g., in the network node device 120) (RX side).

The "partially learned" in diagrams 300, 350 indicates that the respective block implements a combination between digital signal processing and machine learning models. Moreover, in some embodiments, the observation receiver 309 may be replaced by a power detector configured to detect power of out-of-band emissions, as at least in some embodiments this may be sufficient for training a fully learned DPD.

In the example of Fig. 3, the radio transmitter device 200 (e.g., in the client device 130) may generate a bit stream **b** (block 301) which may be encoded and modulated into a complex symbol vector **s** (block 302) that may be orthogonal frequency-division multiplexing (OFDM) -modulated (block 303) to yield an OFDM signal **ri.** The signal may be passed through a first machine learning (ML) model (i.e., the first NN 251) (in block 304) whose objective is to control (e.g., suppress or reduce) ACLR of an amplified signal at the output of the power amplifier (PA) 208. Also, a vector $\theta_1$ may include trainable parameters of the first ML model 251 as the DPD at the radio transmitter device 200. Thus, the first ML model / NN 251 may be modelled as a function $G1(\theta_1, \mathbf{ri})$ which may be implemented as a first neural network with N>1 hidden layers that takes as input the vector **ri** and produces the vector $\mathbf{ro} = G1(\theta_1, \mathbf{ri})$. The first neural network may comprise a deep neural network, a convolutional neural network, or any other suitable neural network, or any combination thereof. The output signal of the first NN 251 may be fed to the PA 208 which may generate a corresponding output signal **ro.** The signal **ro** may be processed by further TX blocks and the resulting signal at the output of a transmit antenna array 206 is denoted as **y.** The output signal **ro** may be expected to be affected by high EVM but low ACLR as a result of the DPD used before the PA 208.

The signal **y** may be sent over the wireless channel 305 with impulse response **h** and the radio receiver device 210 (e.g., in the network node device 120) may receive a signal **u** which is a convolution between the transmitted signal **y** and the channel **h,** corrupted by additive white Gaussian noise (AWGN) **n.** The signal **u** may be OFDM demodulated (block 306) into a signal **u'** and then input to a second ML model (i.e., the second NN 252) (in block 307) whose objective is to remove EVM. Trainable parameters of the second ML model / NN 252 as the DPoD at the radio receiver device 210 may be collected in a vector $\theta_2$. The second ML / NN 252 may thus be seen as implementing a function $G2(\theta_2, \mathbf{u'})$ which may be implemented as a second neural network with N2>1 hidden layers. The second neural network may comprise a deep neural network, a convolutional neural network, or any other suitable neural network, or any combination thereof. Next, channel estimation, equalization and detection may be performed, and the estimated symbols **s'** may further be de-mapped and decoded to RX bits **b'** (block 308). At least in some embodiments, the second ML model / NN 252 may also learn to do other baseband (BB) processing tasks, feeding its output directly to a channel decoder (i.e., a fully learned receiver may be implemented).

In the examples of diagrams 300 and 400, block 310 represents a first intermediate cost function f1 (described in more detail below), block 311 represents a second intermediate cost function f2 (described in more detail below), and block 312 represents a total or combined cost function f (described in more detail below).

The DPD in the radio transmitter device 200 (e.g., in the client device 130) may have various different architectures. For example, the radio transmitter device 200 may comprise a full observation receiver 309 if the radio transmitter device 200 is relying on a conventional DPD, or the radio transmitter device 200 may have a power detector for measuring the out-of-band emissions, if the DPD is implemented using a neural network or ML model -based approach (fully learned). In the latter case, one may learn the DPD parameters $\theta_1$ by observing power of out-of-band emissions, for example.

Fig. 2C is a block diagram of the first training apparatus 220, in accordance with an example embodiment.

The first training apparatus 220 comprises one or more processors 222 and one or more memories 224 that comprise computer program code. The first training apparatus 220 may also include other elements not shown in Fig. 2C.

Although the first training apparatus 220 is depicted to include only one processor 222, the first training apparatus 220 may include more processors. In an embodiment, the memory 224 is capable of storing instructions, such as an operating system and/or various applications. Furthermore, the memory 224 may include a storage that may be used to store, e.g., at least some of the information and data used in the disclosed embodiments, such as copies of the first NN 251 and/or the second NN 252.

Furthermore, the processor 222 is capable of executing the stored instructions. In an embodiment, the processor 222 may be embodied as a multi-core processor, a single core processor, or a combination of one or more multi-core processors and one or more single core processors. For example, the processor 222 may be embodied as one or more of various processing devices, such as a coprocessor, a microprocessor, a controller, a digital signal processor (DSP), a processing circuitry with or without an accompanying DSP, or various other processing devices including integrated circuits such as, for example, an application specific integrated circuit (ASIC), a field programmable gate array (FPGA), a microcontroller unit (MCU), a hardware accelerator, a special-purpose computer chip, a neural network (NN) chip, an artificial intelligence (AI) accelerator, a tensor processing unit (TPU), a neural processing unit (NPU), or the like. In an embodiment, the processor 222 may be configured to execute hard-coded functionality. In an embodiment, the processor 222 is embodied as an executor of software instructions, wherein the instructions may specifically configure the processor 222 to perform the algorithms and/or operations described herein when the instructions are executed.

The memory 224 may be embodied as one or more volatile memory devices, one or more non-volatile memory devices, and/or a combination of one or more volatile memory devices and non-volatile memory devices. For example, the memory 224 may be embodied as semiconductor memories (such as mask ROM, PROM (programmable ROM), EPROM (erasable PROM), flash ROM, RAM (random access memory), etc.).

The first training apparatus 220 may comprise any of various types of digital devices capable of training neural networks. At least in some embodiments, the first training apparatus 220 may be a separate or discrete apparatus, whereas in other embodiments, the first training apparatus 220 may comprised or integrated in the radio transmitter device 200.

When executed by the at least one processor 222, instructions stored in the at least one memory 224 cause the first training apparatus 220 at least to perform at least one of: training the NN 251 used to apply the first distortion operation in the radio transmitter device 200 to control the out-of-band distortion, via minimizing a first intermediate cost function reflecting at least the out-of-band distortion by adjusting one or more trainable parameters of the first NN 251; or training a second NN 252 used to apply the second distortion operation in the radio receiver device 210 to control the in-band distortion, via minimizing a second intermediate cost function reflecting at least the in-band distortion by adjusting one or more trainable parameters of the second NN 252.

When only training the first NN 251 or the second NN 252, the instructions, when executed by the at least one processor 222, further cause the first training apparatus 220 at least to perform indicating to the second training apparatus 230 to perform training the second NN 252 or the first NN 251, respectively.

At least in some embodiments, the instructions, when executed by the at least one processor 222, may further cause the first training apparatus 220 to perform the training via minimizing a combined cost function. The combined cost function is a combination of the first intermediate cost function and the second intermediate cost function.

At least in some embodiments, the instructions, when executed by the at least one processor 222, may further cause the first training apparatus 220 to perform training at least one of the first NN 251 or the second NN 252 via training phases that alternate with interference phases.

In other words and as illustrated in diagram 400 of Fig. 4, the DPD and DPoD at the radio transmitter device 200 and the radio receiver device 210, respectively, may be trained sequentially/iteratively. For example, phases **DPD_Tr** and **DPD_Inf** may be defined for the DPD. In the **DPD_Tr** phase, the DPD may be trained/updated. However, in the **DPD_Inf** phase, the DPD parameters may be frozen and the trained DPD may be used to control the ACLR. E.g., periodic or aperiodic triggering mechanisms may be used to switch between the training and inference phases of the DPD.

Similarly, **DPoD_Tr** and **DPoD_Inf** phases may be defined for the DPoD at the radio receiver device 210. In parallel or sequential modes to the DPD training procedure, the DPoD at the radio receiver device 210 may be trained by switching to the **DPoD_Tr** phase, where the trainable parameters of the DPoD block may be trained/updated to control the EVM of the received signal.

At least in some embodiments, the training/inference phase at one entity may be transparent to the other entity. Alternatively, the operations happening during these phases may be transparent, but the other entity may know when the first entity stopped training, so that their DPD and DPoD versions may remain synchronized.

For example, the instructions, when executed by the at least one processor 222, may further cause the first training apparatus 220 to perform training the first NN 251 via supervised learning or reinforcement learning. For example, the instructions, when executed by the at least one processor 222, may further cause the first training apparatus 220 to perform training the second NN 252 via supervised learning.

In other words, different learning schemes may be considered for training of the DPD and DPoD blocks. For example, supervised learning may be used for both the DPD and DPoD blocks. Alternatively, reinforcement learning (RL) may be used for training the DPD block (a reward may be defined based on the cost functions of f1 and/or f2), while supervised learning is used for training the DPoD block.

Further features of the first training apparatus 220 directly result from the functionalities and parameters of the radio transmitter device 200 and the radio receiver device 210, and thus are not repeated here.

Fig. 2D is a block diagram of the second training apparatus 230, in accordance with an example embodiment.

The second training apparatus 230 comprises one or more processors 232 and one or more memories 234 that comprise computer program code. The second training apparatus 230 may also include other elements not shown in Fig. 2D.

Although the second training apparatus 230 is depicted to include only one processor 232, the second training apparatus 230 may include more processors. In an embodiment, the memory 234 is capable of storing instructions, such as an operating system and/or various applications. Furthermore, the memory 234 may include a storage that may be used to store, e.g., at least some of the information and data used in the disclosed embodiments, such as copies of the first NN 251 and/or the second NN 252.

Furthermore, the processor 232 is capable of executing the stored instructions. In an embodiment, the processor 232 may be embodied as a multi-core processor, a single core processor, or a combination of one or more multi-core processors and one or more single core processors. For example, the processor 232 may be embodied as one or more of various processing devices, such as a coprocessor, a microprocessor, a controller, a digital signal processor (DSP), a processing circuitry with or without an accompanying DSP, or various other processing devices including integrated circuits such as, for example, an application specific integrated circuit (ASIC), a field programmable gate array (FPGA), a microcontroller unit (MCU), a hardware accelerator, a special-purpose computer chip, a neural network (NN) chip, an artificial intelligence (AI) accelerator, a tensor processing unit (TPU), a neural processing unit (NPU), or the like. In an embodiment, the processor 232 may be configured to execute hard-coded functionality. In an embodiment, the processor 232 is embodied as an executor of software instructions, wherein the instructions may specifically configure the processor 232 to perform the algorithms and/or operations described herein when the instructions are executed.

The memory 234 may be embodied as one or more volatile memory devices, one or more non-volatile memory devices, and/or a combination of one or more volatile memory devices and non-volatile memory devices. For example, the memory 234 may be embodied as semiconductor memories (such as mask ROM, PROM (programmable ROM), EPROM (erasable PROM), flash ROM, RAM (random access memory), etc.).

The second training apparatus 230 may comprise any of various types of digital devices capable of training neural networks. At least in some embodiments, the second training apparatus 230 may be a separate or discrete apparatus, whereas in other embodiments, the second training apparatus 230 may comprised or integrated in the radio receiver device 210.

When executed by the at least one processor 232, instructions stored in the at least one memory 234 cause the second training apparatus 230 at least to perform receiving, from the first training apparatus 220, the indication to train the first NN 251 used to apply the first distortion operation in the radio transmitter device 200 to control the out-of-band distortion, or to train the second NN 252 used to apply the second distortion operation in the radio receiver device 210 to control the in-band distortion.

In accordance with the received indication, the instructions, when executed by the at least one processor 232, further cause the second training apparatus 230 at least to perform one of: training the first NN 251 via minimizing the first intermediate cost function reflecting the out-of-band distortion by adjusting the one or more trainable parameters of the first NN 251, or training the second NN 252 via minimizing the second intermediate cost function reflecting the in-band distortion by adjusting the one or more trainable parameters of the second NN 252.

Further features of the second training apparatus 230 directly result from the functionalities and parameters of the radio transmitter device 200, the radio receiver device 210, and the first training apparatus 220, and thus are not repeated here.

As an example, to train the example structure of diagram 300 of Fig. 3, a combined cost function may be used as follows, targeting the two ML blocks 251, 252 separately:

- a first intermediate cost function f1 (block 310 in diagrams 300, 400) may target the first NN 251 and thus aims to minimize ACLR of the signal **y,** i.e., aim to minimize the cost function f1 = ACLR(y,$\theta_1$) by adjusting the parameters of the first NN 251; and

- a second intermediate cost function f2 (block 311 in diagrams 300, 400) may target the second NN 252 and thus aim to minimize EVM. That is, the second NN 252 may learn such parameters $\theta_2$ which result in the distance between the estimated symbols **s'** and the original symbols **s** being minimized, e.g., f2 = MSE (**s'** ,**s**, $\theta_2$). As an alternative, f2 may be defined over the transmitted and detected bits as f2 = CE (**b'** ,**b**, $\theta_2$), where CE denotes a cross-entropy loss function.

At least in some embodiments, the first NN 251 may also target to minimize the second intermediate cost function f2.

The total or combined cost function (block 312 in diagrams 300, 400) may use f1 and f2, e.g., as follows:

- in an embodiment, the cost function used to train both the first and second NNs 251, 252 may be formulated, e.g., as: f = f2 constrained by f1< threshold;
- in another embodiment, the combined cost function may include, e.g.,:

$$ f \;=\; a_1 f_1 \;+\; a_2 f_2, $$

where a1 and a2 weigh the importance of f1 vs f2 and $a_1 + a_2 = 1$.

The trainable parameters of the DPD and DPoD may be obtained, e.g., by minimizing the total/combined loss function:

$$ \widehat{\theta_1}, \widehat{\theta_2} = \underset{\theta_1,\theta_2}{\arg\min} f $$

The radio transmitter device 200 (e.g., in the client device 130) DPD may have various different architectures. For example, the radio transmitter device 200 (e.g., in the client device 130) may have a full observation receiver if it is relying on a conventional DPD, or it may only have a power detector for measuring the out-of-band emissions, if the DPD is done using a neural network -based approach (fully learned). In the latter case, one may learn the DPD parameters $\theta_1$ by observing power of out-of-band emissions, for example.

In an embodiment, the radio transmitter device 200 and/or the radio receiver device 210 may be trained offline.

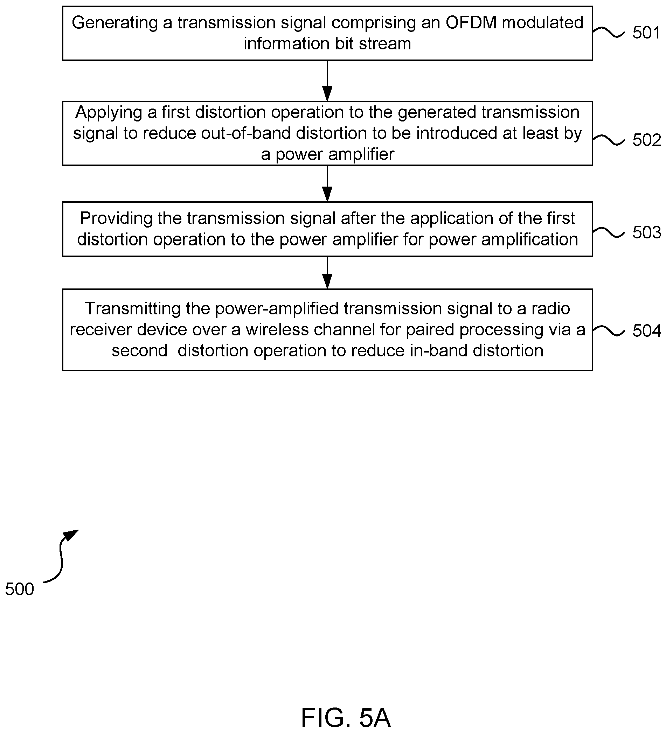

Fig. 5A illustrates an example flow chart of a method 500, in accordance with an example embodiment.

At operation 501, the radio transmitter device 200 generates the transmission signal comprising the OFDM modulated information bit stream.

At operation 502, the radio transmitter device 200 applies the first distortion operation to the generated transmission signal to control the out-of-band distortion to be introduced at least by the power amplifier 208 comprised in the radio transmitter device 200.

At operation 503, the radio transmitter device 200 provides the transmission signal to the power amplifier 208 for the power amplification after the application of the first distortion operation.

At operation 504, the radio transmitter device 200 transmits the power-amplified transmission signal to the radio receiver device 210 over the wireless channel for the collaborative processing via the second distortion operation to control the in-band distortion.

The method 500 may be performed by the radio transmitter device 200 of Fig. 2A. The operations 501-504 can, for example, be performed by the at least one processor 202 and the at least one memory 204. Further features of the method 500 directly result from the functionalities and parameters of the radio transmitter device 200, and thus are not repeated here. The method 500 can be performed by computer program(s).

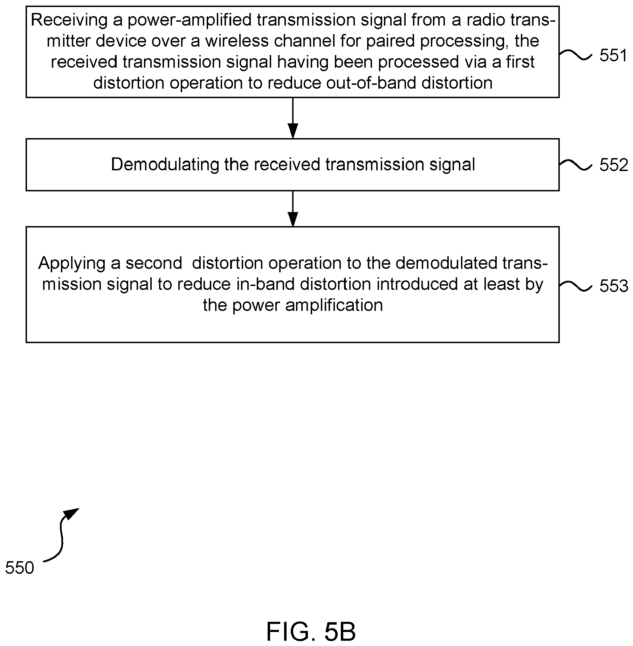

Fig. 5B illustrates an example flow chart of a method 550, in accordance with an example embodiment.

At operation 551, the radio receiver device 210 receives the power-amplified transmission signal from the radio transmitter device 200 over the wireless channel for the collaborative processing. The received transmission signal has been processed via the first distortion operation to control the out-of-band distortion.

At operation 552, the radio receiver device 210 demodulates the received transmission signal.

At operation 553, the radio receiver device 210 applies the second distortion operation to the demodulated transmission signal to control the in-band distortion introduced at least by the power amplification.

The method 550 may be performed by the radio receiver device 210 of Fig. 2B. The operations 551-553 can, for example, be performed by the at least one processor 212 and the at least one memory 214. Further features of the method 550 directly result from the functionalities and parameters of the radio receiver device 210, and thus are not repeated here. The method 550 can be performed by computer program(s).

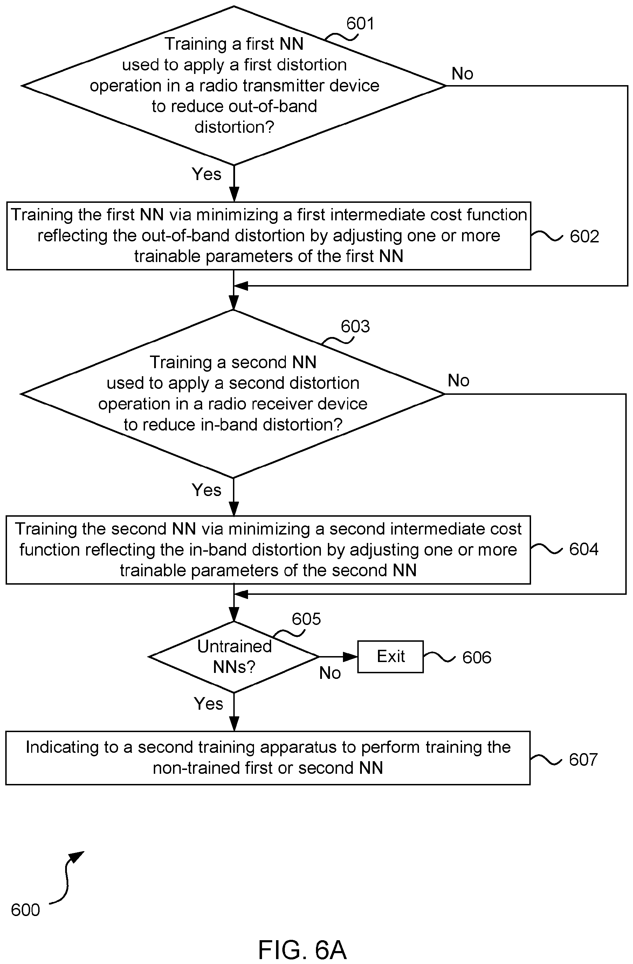

Fig. 6A illustrates an example flow chart of a method 600, in accordance with an example embodiment.

At operation 601, the first training apparatus 220 determines whether to train the first NN 251 used to apply the first distortion operation in the radio transmitter device 200 to control the out-of-band distortion. If yes, the method 600 proceeds to operation 602. Otherwise, the method 600 proceeds to operation 603.

At operation 602, the first training apparatus 220 trains the first NN 251 via minimizing the first intermediate cost function reflecting the out-of-band distortion by adjusting the one or more trainable parameters of the first NN 251.

At operation 603, the first training apparatus 220 determines whether to train the second NN 252 used to apply the second distortion operation in the radio receiver device 210 to control the in-band distortion. If yes, the method 600 proceeds to operation 604. Otherwise, the method 600 proceeds to operation 605.

At operation 604, the first training apparatus 220 trains the second NN 252 via minimizing the second intermediate cost function reflecting the in-band distortion by adjusting the one or more trainable parameters of the second NN 252.

At operation 605, the first training apparatus 220 determines whether the first NN 251 or the second NN 252 remains untrained. If yes, the method 600 proceeds to operation 607. Otherwise, the method 600 exits, operation 606.

At operation 607 (when only training the first NN 251 or the second NN 252), the first training apparatus 220 indicates to the second training apparatus 230 to perform training the second NN 252 or the first NN 251, respectively.

The method 600 may be performed by the first training apparatus 220 of Fig. 2C. The operations 601-607 can, for example, be performed by the at least one processor 222 and the at least one memory 224. Further features of the method 600 directly result from the functionalities and parameters of the first training apparatus 220, and thus are not repeated here. The method 600 can be performed by computer program(s).

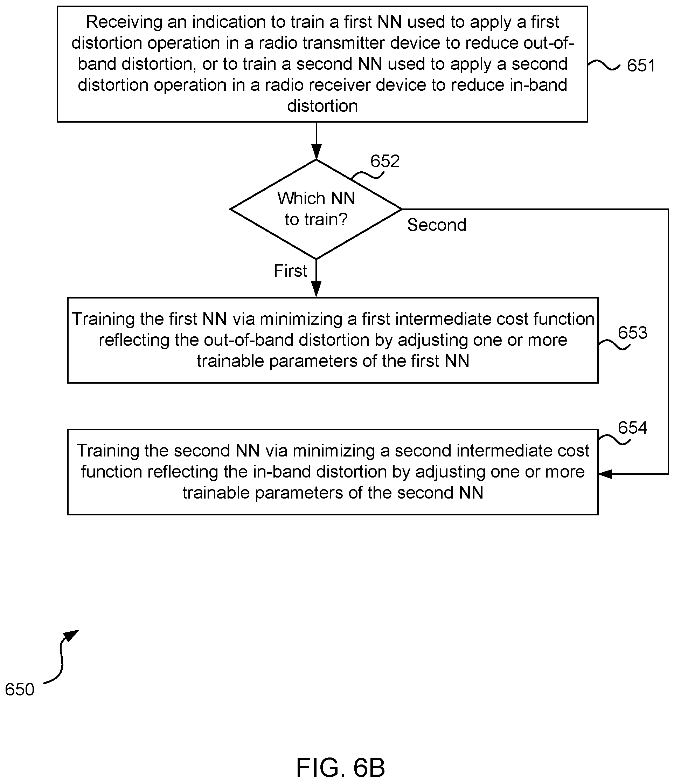

Fig. 6B illustrates an example flow chart of a method 650, in accordance with an example embodiment.

At operation 651, the second training apparatus 230 receives from the first training apparatus 220 the indication to train the first NN 251 used to apply the first distortion operation in the radio transmitter device 200 to control the out-of-band distortion, or to train the second NN 252 used to apply the second distortion operation in the radio receiver device 210 to control in-band distortion.

At operation 652, the second training apparatus 230 determines whether the received indication concerns training the first NN 251 or the second NN 252. If the received indication concerns the first NN 251, the method proceeds to operation 653. If the received indication concerns the second NN 252, the method proceeds to operation 654.

At operation 653, the second training apparatus 230 trains the first NN 251 via minimizing the first intermediate cost function reflecting the out-of-band distortion by adjusting the one or more trainable parameters of the first NN 251.

At operation 654, the second training apparatus 230 trains the second NN 252 via minimizing the second intermediate cost function reflecting the in-band distortion by adjusting the one or more trainable parameters of the second NN 252.

The method 650 may be performed by the second training apparatus 230 of Fig. 2D. The operations 651-654 can, for example, be performed by the at least one processor 232 and the at least one memory 234. Further features of the method 650 directly result from the functionalities and parameters of the second training apparatus 230, and thus are not repeated here. The method 650 can be performed by computer program(s).

The radio transmitter device 200 may comprise means for performing at least one method described herein. In one example, the means may comprise the at least one processor 202, and the at least one memory 204 storing instructions that, when executed by the at least one processor, cause the radio transmitter device 200 to perform the method.

The radio receiver device 210 may comprise means for performing at least one method described herein. In one example, the means may comprise the at least one processor 212, and the at least one memory 214 storing instructions that, when executed by the at least one processor, cause the radio receiver device 210 to perform the method.

The first training apparatus 220 may comprise means for performing at least one method described herein. In one example, the means may comprise the at least one processor 222, and the at least one memory 224 storing instructions that, when executed by the at least one processor, cause the first training apparatus 220 to perform the method.

The second training apparatus 230 may comprise means for performing at least one method described herein. In one example, the means may comprise the at least one processor 232, and the at least one memory 234 storing instructions that, when executed by the at least one processor, cause the second training apparatus 230 to perform the method.

The functionality described herein can be performed, at least in part, by one or more computer program product components such as software components. According to an embodiment, the radio transmitter device 200, the radio receiver device 210, the first training apparatus 220 and/or the second training apparatus 230 may comprise a processor or processor circuitry, such as for example a microcontroller, configured by the program code when executed to execute the embodiments of the operations and functionality described. Alternatively, or in addition, the functionality described herein can be performed, at least in part, by one or more hardware logic components. For example, and without limitation, illustrative types of hardware logic components that can be used include Field-programmable Gate Arrays (FPGAs), Application-specific Integrated Circuits (ASICs), Application-specific Standard Products (ASSPs), System-on-a-chip systems (SOCs), Complex Programmable Logic Devices (CPLDs), Tensor Processing Units (TPUs), and Graphics Processing Units (GPUs).

In the disclosed example embodiments, it may be possible to train one ML model with a specific architecture, then derive another ML model from that using processes such as compilation, pruning, quantization or distillation. The ML model may be executed using any suitable apparatus, for example a CPU, GPU, ASIC, FPGA, compute-in-memory, analog, or digital, or optical apparatus. It is also possible to execute the ML model in an apparatus that combines features from any number of these, for instance digital-optical or analog-digital hybrids. In some examples, weights and required computations in these systems may be programmed to correspond to the ML model. In some examples, the apparatus may be designed and manufactured so as to perform the task defined by the ML model so that the apparatus is configured to perform the task when it is manufactured without the apparatus being programmable as such.

Any range or device value given herein may be extended or altered without losing the effect sought. Also, any embodiment may be combined with another embodiment unless explicitly disallowed.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are intended to be within the scope of the claims.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item may refer to one or more of those items.

The steps of the methods described herein may be carried out in any suitable order, or simultaneously where appropriate. Additionally, individual blocks may be deleted from any of the methods without departing from the spirit and scope of the subject matter described herein. Aspects of any of the embodiments described above may be combined with aspects of any of the other embodiments described to form further embodiments without losing the effect sought.

The term 'comprising' is used herein to mean including the method, blocks or elements identified, but that such blocks or elements do not comprise an exclusive list and a method or apparatus may contain additional blocks or elements.

It will be understood that the above description is given by way of example only and that various modifications may be made by those skilled in the art. The above specification, examples and data provide a complete description of the structure and use of exemplary embodiments. Although various embodiments have been described above with a certain degree of particularity, or with reference to one or more individual embodiments, those skilled in the art could make numerous alterations to the disclosed embodiments without departing from the spirit or scope of this specification.

## Claims

1. A radio transmitter device (200), comprising:

   a power amplifier (208);
   at least one processor (202); and
   at least one memory (204) storing instructions that, when executed by the at least one processor (202), cause the radio transmitter device (200) at least to perform:

   generating a transmission signal comprising an orthogonal frequency division multiplexing, OFDM, modulated information bit stream;
   applying a first distortion operation to the generated transmission signal to control out-of-band distortion to be introduced at least by the power amplifier (208);
   providing the transmission signal to the power amplifier (208) for power amplification after the application of the first distortion operation; and
   transmitting the power-amplified transmission signal to a radio receiver device (210) over a wireless channel for collaborative processing via a second distortion operation to control in-band distortion.

2. The radio transmitter device (200) according to claim 1, wherein the out-of-band distortion comprises an adjacent channel leakage ratio, ACLR.

3. The radio transmitter device (200) according to claim 1 or 2, wherein the application of the first distortion operation is performed at least partially with a first neural network, NN (251).

4. The radio transmitter device (200) according to any of claims 1 to 3, wherein the first distortion operation comprises a digital pre-distortion, DPD, operation, and the second distortion operation comprises a digital post-distortion, DPoD, operation.

5. A method (500), comprising:

   generating (501), by a radio transmitter device (200), a transmission signal comprising an orthogonal frequency division multiplexing, OFDM, modulated information bit stream;
   applying (502), by the radio transmitter device (200), a first distortion operation to the generated transmission signal to control out-of-band distortion to be introduced at least by a power amplifier (208) comprised in the radio transmitter device (200);

providing (503), by the radio transmitter device (200), the transmission signal to the power amplifier (208) for power amplification after the application of the first distortion operation; and

transmitting (504), by the radio transmitter device (200), the power-amplified transmission signal to a radio receiver device (210) over a wireless channel for collaborative processing via a second distortion operation to control in-band distortion.

6. A radio receiver device (210), comprising:

at least one processor (212); and
at least one memory (214) storing instructions that, when executed by the at least one processor (212), cause the radio receiver device (210) at least to perform:

receiving a power-amplified transmission signal from a radio transmitter device (200) over a wireless channel for collaborative processing, the received transmission signal having been processed via a first distortion operation to control out-of-band distortion;

demodulating the received transmission signal; and

applying a second distortion operation to the demodulated transmission signal to control in-band distortion introduced at least by the power amplification.

7. The radio receiver device (210) according to claim 6, wherein the in-band distortion comprises an error vector magnitude, EVM.

8. The radio receiver device (210) according to claim 6 or 7, wherein the application of the second distortion operation is performed at least partially with a second neural network, NN (252).

9. The radio receiver device (210) according to any of claims 6 to 8, wherein the first distortion operation comprises a digital pre-distortion, DPD, operation, and the second distortion operation comprises a digital post-distortion, DPoD, operation.

10. A method (550), comprising:

receiving (551), at a radio receiver device (210), a power-amplified transmission signal from a radio transmitter device (200) over a wireless channel for collaborative processing, the received transmission signal having been processed via a first distortion operation to control out-of-band distortion;

demodulating (552), by the radio receiver device (210), the received transmission signal; and

applying (553), by the radio receiver device (210), a second distortion operation to the demodulated transmission signal to control in-band distortion introduced at least by the power amplification.

11. A first training apparatus (220), comprising:

at least one processor (222); and
at least one memory (224) storing instructions that, when executed by the at least one processor (222), cause the first training apparatus (220) at least to perform at least one of:

training a first neural network, NN, (251) used to apply a first distortion operation in a radio transmitter device (200) to control out-of-band distortion, via minimizing a first intermediate cost function reflecting at least the out-of-band distortion by adjusting one or more trainable parameters of the first NN (251); or

training a second NN (252) used to apply a second distortion operation in a radio receiver device (210) to control in-band distortion, via minimizing a second intermediate cost function reflecting at least the in-band distortion by adjusting one or more trainable parameters of the second NN (252),

wherein when only training the first NN (251) or the second NN (252), indicating to a second training apparatus (230) to perform training the second NN (252) or the first NN (251), respectively.

12. The first training apparatus (220) according to claim 11, wherein the instructions, when executed by the at least one processor (222), further cause the first training apparatus (220) to perform the training via minimizing a combined cost function, the combined cost function being a combination of the first intermediate cost function and the second intermediate cost function.

13. The first training apparatus (220) according to claim 11 or 12, wherein the instructions, when executed by the at least one processor (222), further cause the first training apparatus (220) to perform training at least one of the first NN (251) or the second NN (252) via training phases alternating with interference phases.

14. The first training apparatus (220) according to any of claims 11 to 13, wherein the instructions, when executed by the at least one processor (222), further cause the first training apparatus (220) to perform training the first NN (251) via supervised learning or reinforcement learning.

15. The first training apparatus (220) according to any of claims 11 to 14, wherein the instructions, when executed by the at least one processor (222), further cause the first training apparatus (220) to perform training the second NN (252) via supervised learning.

16. The first training apparatus (220) according to any of claims 11 to 15, wherein the first distortion operation comprises a digital pre-distortion, DPD, operation, and the second distortion operation comprises a digital post-distortion, DPoD, operation.

17. A method (600), comprising at least one of:

  training (602), by a first training apparatus (220), a first neural network, NN, (251) used to apply a first distortion operation in a radio transmitter device (200) to control out-of-band distortion, via minimizing a first intermediate cost function reflecting the out-of-band distortion by adjusting one or more trainable parameters of the first NN (251); or
  training (604), by the first training apparatus (220), a second NN (252) used to apply a second distortion operation in a radio receiver device (210) to control in-band distortion, via minimizing a second intermediate cost function reflecting the in-band distortion by adjusting one or more trainable parameters of the second NN (252),
  wherein when only training the first NN (251) or the second NN (252), the method (600) further comprises indicating (607) by the first training apparatus (220) to a second training apparatus (230) to perform training the second NN (252) or the first NN (251), respectively.

18. A second training apparatus (230), comprising:

  at least one processor (232); and
  at least one memory (234) storing instructions that, when executed by the at least one processor (232), cause the second training apparatus (230) at least to perform:

    receiving, from a first training apparatus (220), an indication to train a first neural network, NN, (251) used to apply a first distortion operation in a radio transmitter device (200) to control out-of-band distortion, or to train a second NN (252) used to apply a second distortion operation in a radio receiver device (210) to control in-band distortion; and
in accordance with the received indication, performing one of:

    training the first NN (251) via minimizing a first intermediate cost function reflecting the out-of-band distortion by adjusting one or more trainable parameters of the first NN (251), or
    training the second NN (252) via minimizing a second intermediate cost function reflecting the in-band distortion by adjusting one or more trainable parameters of the second NN (252).

19. The second training apparatus (230) according to claim 18, wherein the first distortion operation comprises a digital pre-distortion, DPD, operation, and the second distortion operation comprises a digital post-distortion, DPoD, operation.

20. A method (650), comprising:

  receiving (651), at a second training apparatus (230) from a first training apparatus (220), an indication to train a first neural network, NN, (251) used to apply a first distortion operation in a radio transmitter device (200) to control out-of-band distortion, or to train a second NN (252) used to apply a second distortion operation in a radio receiver device (210) to control in-band distortion; and
  in accordance with the received indication, performing one of:

    training (653), by the second training apparatus (230), the first NN (251) via minimizing a first intermediate cost function reflecting the out-of-band distortion by adjusting one or more trainable parameters of the first NN (251), or
    training (654), by the second training apparatus (230), the second NN (252) via minimizing a second intermediate cost function reflecting the in-band distortion by adjusting one or more trainable parameters of the second NN (252).

FIG. 1

200

RADIO TRANSMITTER
DEVICE

204

202

MEMORY 251

206

PROCESSOR

NN 1

ANTENNA(S)

POWER
AMPLIFIER

208

FIG. 2A

210

RADIO RECEIVER DEVICE

214

212

MEMORY 252

216

PROCESSOR

NN 2

ANTENNA(S)

FIG. 2B

FIG. 2C

FIG. 2D

FIG. 3

EP 4 531 292 A1

TX USER DEVICE · RX NETWORK NODE

301 — TX bits

302 — Bit-to-symbol mapping

303 — OFDM modulation

304 — Partially or fully learned DPD

208 — Power amplifier

305 — Channel

306 — OFDM demodulation

307 — Partially or fully learned receiver, incl. DoPD

308 — RX bits

309 — Observation receiver

310 — ACLR-based loss term f1

311 — Throughput-based loss term f2

400

FIG. 4

EP 4 531 292 A1

| | |
|---|---|
| Generating a transmission signal comprising an OFDM modulated information bit stream | 501 |
| Applying a first distortion operation to the generated transmission signal to reduce out-of-band distortion to be introduced at least by a power amplifier | 502 |
| Providing the transmission signal after the application of the first distortion operation to the power amplifier for power amplification | 503 |
| Transmitting the power-amplified transmission signal to a radio receiver device over a wireless channel for paired processing via a second distortion operation to reduce in-band distortion | 504 |

500

FIG. 5A

Receiving a power-amplified transmission signal from a radio transmitter device over a wireless channel for paired processing, the
received transmission signal having been processed via a first
distortion operation to reduce out-of-band distortion

~ 551

Demodulating the received transmission signal

~ 552

Applying a second distortion operation to the demodulated trans-
mission signal to reduce in-band distortion introduced at least by
the power amplification

~ 553

550

FIG. 5B

```
                    ┌──────────────────────────────┐
                   ╱         Training a first NN     ╲      601
                  ╱   used to apply a first distortion ╲
                 ╱   operation in a radio transmitter device ╲   No
                 ╲      to reduce out-of-band         ╱ ─────────────┐
                  ╲         distortion?              ╱               │
                   ╲──────────────────────────────╱                 │
                              │ Yes                                  │
                              ▼                                      │
   ┌─────────────────────────────────────────────────────────┐      │
   │ Training the first NN via minimizing a first intermediate │      │
   │ cost function reflecting the out-of-band distortion by    │~ 602 │
   │ adjusting one or more trainable parameters of the first NN│      │
   └─────────────────────────────────────────────────────────┘      │
                              │ ◄──────────────────────────────────┘
                              ▼
                    ┌──────────────────────────────┐
                   ╱         Training a second NN    ╲      603
                  ╱   used to apply a second distortion ╲
                 ╱   operation in a radio receiver device ╲   No
                 ╲      to reduce in-band distortion?     ╱ ──────────┐
                  ╲                                      ╱            │
                   ╲──────────────────────────────────╱              │
                              │ Yes                                  │
                              ▼                                      │
   ┌─────────────────────────────────────────────────────────┐      │
   │ Training the second NN via minimizing a second intermediate│     │
   │ cost function reflecting the in-band distortion by        │~ 604 │
   │ adjusting one or more trainable parameters of the second NN│     │
   └─────────────────────────────────────────────────────────┘      │
                              │ ◄──────────────────────────────────┘
                              ▼
                        ╱ Untrained ╲  605        ┌──────┐
                       ╱    NNs?      ╲ ──────────►│ Exit │ ~ 606
                        ╲            ╱   No        └──────┘
                              │ Yes
                              ▼
   ┌─────────────────────────────────────────────────────────┐
   │ Indicating to a second training apparatus to perform     │
   │ training the non-trained first or second NN              │~ 607
   └─────────────────────────────────────────────────────────┘
```

**Training a first NN** used to apply a first distortion operation in a radio transmitter device to reduce out-of-band distortion? — 601 — No

Yes

Training the first NN via minimizing a first intermediate cost function reflecting the out-of-band distortion by adjusting one or more trainable parameters of the first NN — 602

**Training a second NN** used to apply a second distortion operation in a radio receiver device to reduce in-band distortion? — 603 — No

Yes

Training the second NN via minimizing a second intermediate cost function reflecting the in-band distortion by adjusting one or more trainable parameters of the second NN — 604

Untrained NNs? — 605 — No → Exit — 606

Yes

Indicating to a second training apparatus to perform training the non-trained first or second NN — 607

600

FIG. 6A

Receiving an indication to train a first NN used to apply a first distortion operation in a radio transmitter device to reduce out-of-band distortion, or to train a second NN used to apply a second distortion operation in a radio receiver device to reduce in-band distortion — 651

Which NN to train? — 652

Second

First

Training the first NN via minimizing a first intermediate cost function reflecting the out-of-band distortion by adjusting one or more trainable parameters of the first NN — 653

Training the second NN via minimizing a second intermediate cost function reflecting the in-band distortion by adjusting one or more trainable parameters of the second NN — 654

650

FIG. 6B

Europäisches
Patentamt

European
Patent Office

Office européen
des brevets

# EUROPEAN SEARCH REPORT

Application Number

EP 23 19 9662

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/299800 A1 (KUTZ GIDEON SHLOMO [IL] ET AL) 21 September 2023 (2023-09-21) <br> * paragraph [0033] - paragraph [0040] * <br> * paragraphs [0005], [0197] * <br> * paragraph [0096] - paragraph [0098] * <br> * figures 1-7 * <br> ----- | 1-10 | INV. <br> H04B1/04 <br> H04B1/62 <br> H04B1/02 <br> H04B1/10 <br> H03F1/32 <br> G06N3/02 |
| X | US 2021/119682 A1 (GUTMAN IGOR [IL] ET AL) 22 April 2021 (2021-04-22) <br> * paragraph [0060] - paragraph [0067] * <br> * figures 3,4 * <br> ----- | 1,7 | |
| A | WO 2023/083453 A1 (ERICSSON TELEFON AB L M [SE]) 19 May 2023 (2023-05-19) <br> * paragraphs [0072], [0073], [0076] * <br> * figures 9-15 * <br> ----- | 11-20 | |
| A | WO 2022/073752 A1 (NOKIA SOLUTIONS & NETWORKS OY [FI]) 14 April 2022 (2022-04-14) <br> * figures 1-3 * <br> * figures 15-17 * <br> ----- | 11-20 | TECHNICAL FIELDS SEARCHED (IPC) <br><br> H04B |

The present search report has been drawn up for all claims

| Place of search | Date of completion of the search | Examiner |
|---|---|---|
| Munich | 27 May 2024 | Avilés Martínez, L |

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

The Search Division considers that the present European patent application does not comply with the requirements of unity of invention and relates to several inventions or groups of inventions, namely:

1. claims: 1-10

   A radio transmitter device and corresponding radio receiver, the transmitter comprising:
   a power amplifier;
   at least one processor; andat least one memory storing instructions that, when executed by the at least one processor, cause the radio transmitter device at least to perform:generating a transmission signal comprising an orthogonal frequency division multiplexing, OFDM, modulated information bit stream;applying a first distortion operation to the generated transmission signal to control out-of-band distortion to be introduced at least by the power amplifier;providing the transmission signal to the power amplifier for power amplification after the application of the first distortion operation; andtransmitting the power-amplified transmission signal to a radio receiver device over a wireless channel for collaborative processing via a second distortion operation to control in-band distortion,
   the receiver comprising:
   at least one processor; andat least one memory storing instructions that, when executed by the at least one processor, cause the radio receiver device at least to perform:receiving a power-amplified transmission signal from a radio transmitter device over a wireless channel for collaborative processing, the received transmission signal having been processed via a first distortion operation to control out-of-band distortion;demodulating the received transmission signal; andapplying a second distortion operation to the demodulated transmission signal to control in-band distortion introduced at least by the power amplification.

   - - -

2. claims: 11-20

   A first training apparatus, comprising:
   at least one processor; and
   at least one memory storing instructions that, when executed by the at least one processor, cause the first training apparatus at least to perform at least one of:
   training a first neural network, NN, used to apply a first distortion operation in a radio transmitter device to control out-of-band distortion, via minimizing a first intermediate cost function reflecting at least the out-of-band distortion by adjusting one or more trainable parameters of the first NN; or
   training a second NN used to apply a second distortion operation in a radio receiver device to control in-band distortion, via minimizing a second intermediate cost

Europäisches
Patentamt

European
Patent Office

Office européen
des brevets

**LACK OF UNITY OF INVENTION
SHEET B**

Application Number

EP 23 19 9662

The Search Division considers that the present European patent application does not comply with the requirements of unity of invention and relates to several inventions or groups of inventions, namely:

```
function reflecting at least the in-band distortion by
adjusting one or more trainable parameters of the second NN,
wherein when only training the first NN or the second NN,
indicating to a second training apparatus to perform
training the second NN or the first NN, respectively.
                          - - -
```

**EP 4 531 292 A1**

## ANNEX TO THE EUROPEAN SEARCH REPORT
## ON EUROPEAN PATENT APPLICATION NO.

EP 23 19 9662

27-05-2024

| Patent document cited in search report | Publication date | Patent family member(s) | | Publication date |
|---|---|---|---|---|
| US 2023299800 A1 | 21-09-2023 | US | 2023299800 A1 | 21-09-2023 |
| | | WO | 2023177937 A1 | 21-09-2023 |
| US 2021119682 A1 | 22-04-2021 | CN | 114556799 A | 27-05-2022 |
| | | EP | 4046346 A1 | 24-08-2022 |
| | | US | 2021119682 A1 | 22-04-2021 |
| | | WO | 2021077050 A1 | 22-04-2021 |
| WO 2023083453 A1 | 19-05-2023 | NONE | | |
| WO 2022073752 A1 | 14-04-2022 | CN | 115462040 A | 09-12-2022 |
| | | CN | 116601876 A | 15-08-2023 |
| | | EP | 4118798 A1 | 18-01-2023 |
| | | EP | 4226511 A1 | 16-08-2023 |
| | | FI | 20205261 A1 | 13-09-2021 |
| | | FI | 20205990 A1 | 13-09-2021 |
| | | JP | 2023517681 A | 26-04-2023 |
| | | US | 2023362042 A1 | 09-11-2023 |
| | | US | 2023403182 A1 | 14-12-2023 |
| | | WO | 2021181002 A1 | 16-09-2021 |
| | | WO | 2022073752 A1 | 14-04-2022 |

EPO FORM P0459